# EUROPEAN PATENT SPECIFICATION

(11) **EP 2 092 528 B1**
(45) Date of publication and mention of the grant of the patent: **10.10.2012**
(21) Application number: 07826953.7
(22) Date of filing: 02.11.2007
(51) Int. Cl.: G11C 13/00, G11C 13/02, H01L 51/00, H01L 51/05, B82Y 10/00

(54) **MEMORY DEVICE AND METHOD FOR FABRICATING A MEMORY DEVICE**
SPEICHERANORDNUNG UND VERFAHREN ZUR HERSTELLUNG EINER SPEICHERANORDNUNG
DISPOSITIF DE MÉMOIRE ET PROCÉDÉ POUR FABRIQUER UN DISPOSITIF DE MÉMOIRE

(30) Priority: 29.11.2006 EP 06125027
(43) Date of publication of application: 26.08.2009
(73) Proprietor: International Business Machines Corporation, Armonk, NY 10504 (US)
(72) Inventor: REPP, Jascha, 93053 Regensburg (DE); MEYER, Gerhard, 8134 Adliswil (CH)
(74) Representative: Ragot, Sébastien Pierre
(86) International application number: PCT/IB2007/054448
(87) International publication number: WO 2008/065558

(56) References cited:
- WO-A-2006/101241
- WO-A-2006/118294
- REPP A ET AL: "Imaging bond formation between a gold atom and pentacene on an insulating surface" SCIENCE AMERICAN ASSOC. ADV. SCI USA, vol. 312, no. 5777, 26 May 2006 (2006-05-26), pages 1196-1199, XP002468370 ISSN: 0036-8075
- REPP J ET AL: "Controlling the charge state of individual gold adatoms" SCIENCE AMERICAN ASSOC. ADV. SCI USA, vol. 305, no. 5683, 23 July 2004 (2004-07-23), pages 493-495, XP002468418 ISSN: 0036-8075 cited in the application
- JASCHA REPP, GERHARD MEYER: "Rastertunnelmikroskop bildet Molekülorbitale ab" PHYS. UNSERER ZEIT, June 2006 (2006-06), pages 266-271, XP002468371
- KARL-HEINZ RIEDER ET AL: "Force induced and electron stimulated STM manipulations: routes to artificial nanostructures as well as to molecular contacts, engines and switches" JOURNAL OF PHYSICS: CONFERENCE SERIES, INSTITUTE OF PHYSICS PUBLISHING, BRISTOL, GB, vol. 19, no. 1, 1 January 2005 (2005-01-01), pages 175-181, XP020094000 ISSN: 1742-6596
- REPP J ET AL: "Scanning tunneling microscopy of adsorbates on insulating films. From the imaging of individual molecular orbitals to the manipulation of the charge state" APPLIED PHYSICS A; MATERIALS SCIENCE & PROCESSING, SPRINGER-VERLAG, BE, vol. 85, no. 4, 23 September 2006 (2006-09-23), pages 399-406, XP019442335 ISSN: 1432-0630

## Description

### FIELD OF THE INVENTION

The present invention relates to a memory device, in particular to a memory cell and a memory cell array, wherein information is stored in terms of molecular and/or atomic states. The invention further relates to a method for fabricating a corresponding single-atom and single-molecule memory device.

### BACKGROUND OF THE INVENTION

Today's electronic memory devices are mostly realized in terms of semiconductor based technology wherein memory cells are implemented by transistor circuits that can be brought into logic high or logic low states. A variety of such memory cells based on semiconductor technology is known for a large range of application purposes. The efficiency of such memories in terms of power consumption, reliability and velocity mainly depends on the size of such semiconductor elements, i.e. the transistors. Therefore, a large-scale miniaturization and integration of semiconductor based electronics took place over the last decades. Also solutions alternative to semiconductor- and transistor-based memories were proposed that would enable even smaller devices having lower power consumption and would allow faster switching cycles.

In what is referred to as nanotechnology, single molecules, even atoms, are manipulated mechanically or electrically and may serve as means for storing information. In J. Repp et al. "Controlling the Charge State of Individual Gold Adatoms" Science 305 493 (2004) a way to control the charge state of a single gold (Au) on a sodium chloride (in NaCl) film is disclosed. In said document, the negatively charged gold atom (Au⁻) would correspond to a first logic state while the neutral gold atom (Au⁰) adsorbed on the NaCl-film would correspond to the second logic state. The current through the atom then changes depending on the charge state which could be changed by applying voltage pulses. To read information stored by the charge state of the gold atom a tunneling current has to be sent through the atom. The difference in this tunneling current between the two charge states which is quantified as an on/off-ratio, is usually very small, i.e. in the range of 3, which is far too low for any industrial application. It is therefore desirable to have molecular or atomic memory devices showing a large on/off ratio of a current fed through them corresponding to different logic states.

A sandwiched structure containing a metal/perylenetetracarboxylicacid-dianhydride (PTCDA)/metal sequence used as a two-terminal device having the metal contacts as terminals is disclosed in R. Agrawal, S. Ghosh: "Mechanism of Electric Field Induced Conductance Transition in Molecular Organic Semiconductor Based Thin Films" cond-mat 0604219. According to this document electrical conductivity of the organic PTCDA is caused by migration of metal clusters or metal nanoparticles into the organic layer. Electrical field induced percolation causes conducting pathways through such metallic nanoparticles. To switch between on and off states an electrical field of 60-100 KV/cm is used between the two metal electrodes. In the system according to cond-mat 0604219, several organic layers of PTCDA are involved.

Known single-molecule or single-atom devices suffer the disadvantage that electric molecular states corresponding to logic states are only stable over short time scales and need to be operated at extremely low temperatures. This makes them mostly unsuitable for industrial applications.

Accordingly, it is desirable to provide a memory device based on molecular components that enables simpler reading and writing of logic state.

The paper entitled "Imaging Bond Formation Between a Gold Atom and Pentacene on an Insulating Surface", Jascha Repp, Gerhard Meyer, Sami Paavilainen, Fredrik E. Olsson, and Mats Persson (26 May 2006),Science 312 (5777), 1196, describes the formation of a covalent bond between an individual pentacene molecule and a gold atom by means of single-molecule chemistry inside a scanning tunneling microscope junction. The bond formation is reversible, and different structural isomers can be produced. The single-molecule synthesis was done on ultrathin insulating films that electronically isolated the reactants and products from their environment. Direct imaging of the orbital hybridization upon bond formation provides insight into the energetic shifts and occupation of the molecular resonances.

The document WO 2006101241 relates to a memory element comprising: a first conductive layer; a second conductive layer; an organic compound layer interposed between the first conductive layer and the second conductive layer; and a first insulating layer with a thickness of 0.1 nm or more and 4 nm or less being provided between the first conductive layer and the second conductive layer and in contact with the first conductive layer. A second insulating layer with a thickness of 0.1 nm or more and 4 nm or less can be provided between the first conductive layer and the second conductive layer and in contact with the second conductive layer.

### SUMMARY OF THE INVENTION

According to an embodiment of an aspect of the present invention, there is provided a memory device comprising a molecule-atom complex arranged on an insulating layer wherein a first memory state of the memory device corresponds to a first charge distribution state of the molecule-atom complex and a second memory state of the memory device corresponds to a second charge distribution state of the molecule-atom complex. The total charge of the molecule-atom complex corresponding to the first memory state is equal to the total charge of the molecule-atom complex corresponding to the second memory state. Further the first insulating layer is formed on a first contact layer and the molecule-atom complex comprises at least one single atom, and at least one molecule on the insulating layer.

By forming the complex of an individual molecule and an individual atom, the current change depending on the charge distribution states becomes pronounced, and detection becomes feasible by technological means. Further, the total charge of the molecule-atom complex is conserved when changing from one state to the other. Such a device shows a higher on/off ratio of a tunneling current through the molecule-atom complex when an electrical current is created by sequential electron tunneling on and off the molecule-atom complex. The first insulating layer can be regarded as a tunnel junction.

The single atom and the molecule of the molecule-atom complex are as closely arranged on the first insulating layer that a chemical bond forms between the molecule and the single atom. It is therefore likely that a common electron system of the atom and the molecule forms by developing e.g. a covalent or ionic bond. The closer the molecule and the single atom are placed the higher is the bonding probability for creating the molecule atom complex. Also several individual atoms can be placed in the vicinity of the molecule to form more complex molecule-atom complexes.

In an embodiment of the present invention, the memory device further comprises a second insulating layer arranged on the molecule-atom complex and a second contact layer arranged on the second insulating layer. The second insulating layer thereby forms a second tunnel junction between the molecule-atom complex and the contact layer. Hence, the system can be regarded as a double-barrier structure having the molecule-atom complex in between.

In a further embodiment of the present invention, a contact means is arranged in the vicinity of the molecule-atom complex wherein the contact means and the molecule atom complex are separated by a void space. Consequently, the void space forms a second tunnel junction between the molecule-atom complex and the contact means. This also leads to a double barrier structure where e.g. the contact means can be the tip of a scanning tunneling microscope (STM).

In an embodiment of the present invention, the first insulating layer comprises a polarizable material wherein the polarizable material is polarized in response to the first and/or second charge distribution state of the molecule-atom complex. In a further embodiment, also the second insulating layer comprises a polarizable material wherein the polarizable material is polarizable in response to the first and/or second charge distribution state of molecule-atom complex. A corresponding polarization of the first and/or second insulating layer leads to increased stability of the charge distribution states corresponding to logic states of the actual memory. Therefore, the use of polarizable material improves the temperature range in which an embodiment of the present invention can be operated.

In another embodiment of the present invention, a bias voltage is applied between the first contact layer and the second contact layer or between the first contact layer and the contact means respectively, thereby inducing the first memory state or the second memory state. According to an embodiment of the present invention, the memory states may be set by applying voltages to conducting or metal contacts without changing the total charge of the respective molecule-atom complex. Hence, an embodiment of the present invention corresponds to a memory device based on molecular and atomic components.

In an embodiment of the present invention, the first memory state is switched into the second memory state if a bias voltage is applied between the first contact layer and the second contact layer, and the bias voltage exceeds a respective predetermined threshold voltage. Alternatively the state is switched if a respective bias voltage between the first contact layer and the contact means exceeds a respective predetermined threshold value of the bias voltage.

Preferably, an energy of at least one molecular state of the molecule of the molecule-atom complex is close to the Fermi energy of the first contact layer. By choosing the energy of a molecular state and the Fermi energy in a similar energy range, tunneling and thereby electronic transport through the molecule-atom complex is enhanced. E.g. the Fermi energy of the first contact layer can be tunable in particular by changing a crystal orientation of the first contact layer. The Fermi energy of a contact layer which is formed by semiconductor material can be tuned by appropriate doping of the semiconductor.

In a further embodiment of the present invention, a difference between a work function of the first contact layer, an electron affinity or ionization potential of the molecule of the molecule-atom complex, and/or an electron affinity or ionization potential of the single atom is within a range of 1.5 eV.

Preferably, the molecule atom complex in an embodiment of the present invention may exhibit further charge-distribution states corresponding to further memory states of the memory device.

The molecule is preferably an organic molecule, and in particular a molecule of the group of oligoacenes, Metal-Phthalocyanines, or perylenetetracarboxylicacid-dianhydride (PTCDA). Such a molecule comprises a de-localized electronic system which enhances the formation of a common electron system with the individual atom for forming the molecule-atom complex. The single atom is preferably a metal atom, e.g. a gold atom, but can be platinum, silver, copper etc..

The insulating layer comprises preferably mono-, bi- or trilayers of sodium chloride (NaCl) but can also comprise other substances as metal oxides, other alkali halides, etc.. The first contact layer comprises preferably copper.

According to an embodiment of another aspect of the present invention, a memory cell is provided comprising a first contact layer, a first insulating layer on the first contact layer, a molecule-atom complex arranged on the first insulating layer, a second insulating layer on the molecule-atom complex and a second contact layer on the second insulating layer. Thereby, the first and the second insulating layer each form a tunnel junction between the molecule-atom complex and the first contact layer and the second contact layer between the molecule-atom complex, respectively.

The molecule-atom complex comprises a single atom and a molecule, the molecule-atom complex having at least a first charge distribution state corresponding to a first memory state of the memory cell and a second charge distribution state corresponding to a second memory state of the memory cell.

The total charge of the molecule-atom complex corresponding to the first memory state is equal to the total charge of the molecule-atom complex corresponding to the second memory state. The molecule-atom complex may also contain more than one individual atom brought into the vicinity of a molecule to form more sophisticated complexes.

In a memory cell embodying the present invention, the molecule-atom complex is embedded between the first insulating layer and the second insulating layer wherein the first and the second insulating layer comprise a polarizable material for mechanically and electrostatically suppressing thermal diffusion of the single atom and the molecule of the molecule-atom complex. By encapsulating the molecule-atom complex, a diffusion of undesired impurities can be avoided. Further by mechanically stabilizing the molecule-atom complex, thermal excitations that may overlap the energy states of the charge distribution states can advantageously be reduced. Hence, operation at higher temperatures is possible.

In a memory cell embodying the present invention, a plurality of molecule-atom complexes of the same type are arranged between the first contact layer and the second contact layer. The plurality of molecule-atom complexes is then separated from the first contact layer by the first insulating layer and the plurality of molecule-atom complexes is separated from the second contact layer by the second insulating layer. If several molecule-atom complexes are employed as molecular memory, an average current between the first contact layer and the second contact layer arising from sequentially tunneling through the charge distribution states of the molecule-atom complexes can be detected and assigned to a memory state. Still by applying a bias voltage to the contact layers, a respective memory state can be written by inducing the desired charge distribution states. Preferably the plurality of molecule-atom complexes is realized as a monolayer of the molecule-atom complexes.

In an embodiment of the present invention, the molecule of the molecule-atom complex is chosen as perylenetetracarboxylicacid-dianhydride (PTCDA); the single atom, a gold, a platinum or a silver atom; the first and/or second insulating layer comprise a mono-layer, bi-or trilayer of NaCl, a metal oxide or a semiconductor oxide; and the first and/or second contact layer comprises copper or a semiconductor material.

According to an embodiment of a further aspect of the present invention, a memory cell array is provided comprising a plurality of memory cells according to an embodiment of the present invention as above-described. A memory cell is arranged between a word-line and a bit-line wherein a word-line is electrically coupled to the first contact layer of the memory cell and the bit-line is electrically coupled to the second contact layer of the memory cell. In preferred embodiments of the respective memory cell array, a set of memory cells may share a common word-line. Further, the first contact layers of the memory cells of the set of memory cells may be implemented as the common word-line. Preferably, the memory-cell array comprises a plurality of sets of memory cells wherein a selection of the second contact layers of the memory cells of the plurality of sets of memory cells are implemented as common bit-lines.

According to an embodiment of yet another aspect of the present invention, a method for fabricating a memory cell is provided wherein the method comprises the following method steps:
- providing a first contact layer;
- providing a first insulating layer on the first contact layer;
- providing at least one molecule on the first insulating layer;
- placing a single atom in the vicinity of the at least one molecule, wherein a distance between the molecule and the single atom is adjusted in such a manner that a chemical bond forms between the molecule and the single atom resulting in a molecule-atom complex;
- providing a second insulating layer on the molecule-atom complex; and
- providing a second contact layer onto the second insulating layer, wherein
   the molecule and the single atom are chosen in a manner that the molecule-atom complex has a first charge distribution state and a second charge-distribution state wherein the first and the second charge distribution state correspond to the same total charge of the molecule-atom complex.

The step of providing the first insulating layer on the first contact layer may comprise the step of evaporating insulating material onto the contact layer. The step of providing at least one molecule on the first insulating layer may comprise evaporating a molecular material onto the insulating layer. For providing at least one molecule on the first insulating layer a self-assembly technique may be employed. Molecular self-assembly techniques are known for creating single PTCDA layers. Further, for placing the single atom in the vicinity of the at least one molecule, a tip of a scanning tunneling microscope or self-assembly techniques may be employed. In a preferred embodiment, the first contact layer and/or the second contact layer comprise a copper single crystal.

In the following exemplary embodiments of the memory device and memory cell according to the present invention and methods for fabricating such memories are described with reference to the enclosed figures.

### BRIEF DESCRIPTION OF THE DRAWINGS

Figure 1 shows a basic view of an embodiment of a memory device according to the invention;
Figure 2 shows a perspective view of a molecular arrangement suitable for an embodiment of a memory device according to the invention;
Figure 3 shows polarization effects in an embodiment of the memory device according to the invention;
Figure 4 shows a current-voltage characteristic of an embodiment of a memory device according to the invention for two memory states;
Figure 5 shows a switching cycle of an embodiment of a memory device according to the invention;
Figures 6 - 9 show views of exemplary embodiments of memory devices and cells according to the invention;
Figure 10 shows a memory cell array according to an embodiment of the present invention; and
Figure 11 shows a sequence of method steps for fabricating a memory cell according to an embodiment of the present invention.

Like or functionally like elements in the drawings have been allotted the same reference characters if not otherwise indicated.

### DETAILED DESCRIPTION OF PREFERRED EMBODIMENTS

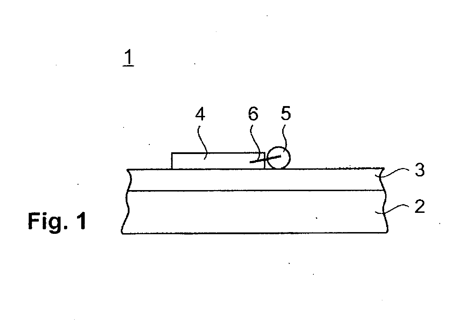

Figure 1 shows a schematic drawing of a first embodiment of a memory cell based on molecular components according to an embodiment of the present invention. Memory device 1 comprises a conducting layer 2, also referred to as a contact layer herein, e.g. implemented as single crystal copper, and an insulating layer 3, for instance comprising an NaCl-monolayer, a molecule 4, e.g. a PTCDA-molecule, and an individual atom 5, e.g. a gold atom. The PTCDA molecule 4 and the gold atom 5 are arranged as closely that a chemical bond 6 between the gold atom 5 and the PTCDA 4 may develop, thereby giving rise to a molecule-atom complex. This may occur e.g. when the molecular orbital of the PTCDA molecule overlaps with the gold atom. The molecule-atom complex shows two distinct charge-distribution states that can be detected separately. Contrary to what is observed for single gold adatoms on NaCl layers, the molecule-atom complex does not change its total charge when switching from one charge distribution state to the other. Moreover, the ratio of tunnel currents through the molecule-atom complex in the first state and through the molecule-atom complex in its second state is enhanced.

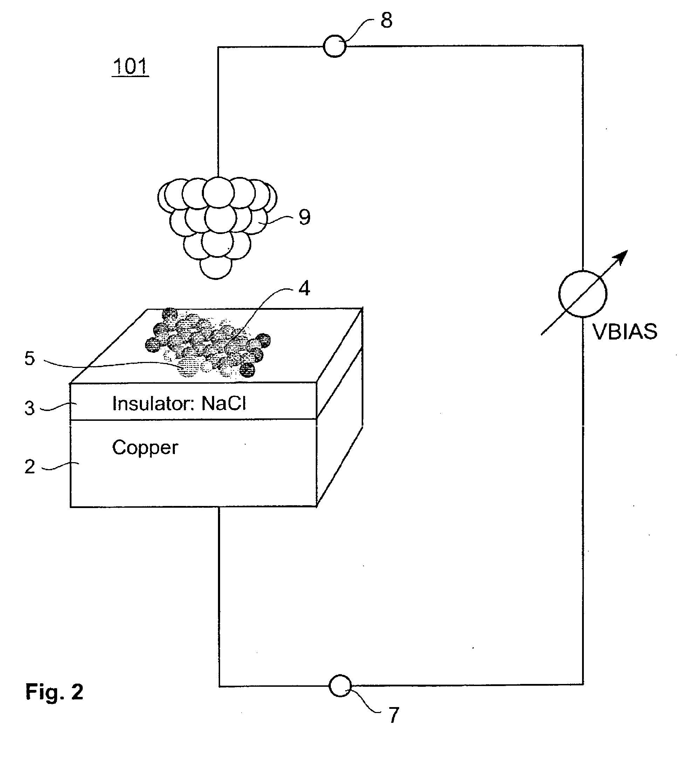

Figure 2 shows a perspective view of an arrangement suitable for a memory device according to an embodiment of the present invention. The arrangement 101 comprises a copper substrate 2 preferably as a defect-free (111) Cu single crystal. On the copper surface NaCl can be evaporated thermally to produce e.g. two mono-layers of NaCl 3. On the two NaCl mono-layers 3 a PTCDA molecule 4 is placed as well as an individual gold atom 5. The π-conjugated PTDCA molecule 4 and the gold atom 5 are very close e.g. in the range of a few nanometers on the NaCl film 3. The consequential forming PTCDA-gold complex shows two different molecular resonances corresponding to two possible charge states of the gold atom inside the complex. However, the total charge of the molecule-atom complex remains constant.

The PTCDA and the gold may be arranged by the tip of a scanning tunneling microscope shown as 9 in figure 2. The arrangement 101 can be regarded as a two-terminal device, a first terminal 7 electrically coupled to the copper substrate 2 and a second terminal 8 coupled to the tip 9. Depending on the charge-distribution state of the molecule-atom complex the current through the device changes drastically. Electrical current flows through sequential tunneling events from the copper substrate 2 onto the PTCDA-Au complex and to the tip 9 or in opposite direction depending on a bias voltage applied VBIAS to the two terminals 7, 8. By changing a respective bias voltage VBIAS the molecular state or charge-distribution state, respectively, of the PTCDA-Au complex can be induced and remains stable. Therefore by programming the charge-distribution state and detecting the charge distribution state of the molecule-atom complex information can be stored and read on a molecular scale.

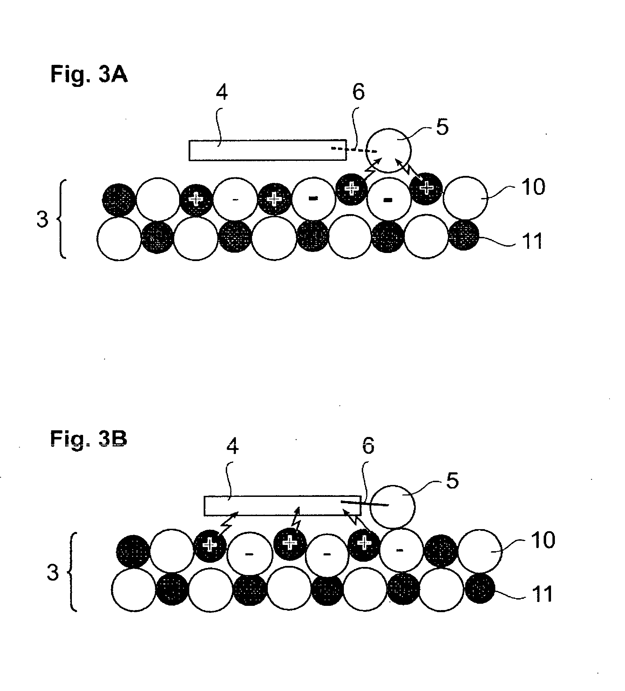

Figures 3A and 3B illustrate the role of the insulating layer 3 e.g. realized by an NaCl atomic layer through stabilizing the molecular charge-distribution states of the PTCDA-Au complex. Figures 3A and 3B show a layer of NaCl 3 wherein sodium ions (Na) are shown as small circles 11 and chlorine (Cl) ions are shown as larger circles 10. On this mono-atomic layer 3, the PTCDA molecule 4 and the gold atom 5 are placed in a manner where the gold atom 5 overlaps the molecular orbital of the PTCDA thereby forming a chemical bond 6.This results in a molecule-atom complex. Since sodium chloride is subject to polarization by the PTCDA-Au, a change in the charge distribution of the PTCDA-Au complex translates into a change of the polarization of the NaCl surface. Figure 3A refers to the first charge-distribution state of the molecule-atom complex, PTCDA-Au complex respectively, where the gold atom 5 or the gold ion is negatively charged, and the PTCDA molecule remains neutral. Therefore the total charge of the PTCDA-Au complex is negative. The electrostatic interaction of the sodium ions 11 and the chlorine ions 10 with the negatively charged gold 5 enhances the stability of the charge-distribution state of the molecule-atom complex.

When switching to the second charge-distribution state of the PTCDA-gold complex, again the polarizability of the insulating sodium chloride layer 3 gives rise to relaxation processes and therefore an improved stability of second charge-distribution state. This is shown in figure 3B where the PTCDA complex is negatively charged while the gold atom 5 is neutral. Again, the positive sodium ions 11 are attracted while the negative chlorine ions 10 are repelled by the negative PTCDA 4. The change in the charge distribution and hence the molecular state of the molecule-gold complex is indicated by a change in the chemical bond 6 between gold 5 and PTCDA 4.

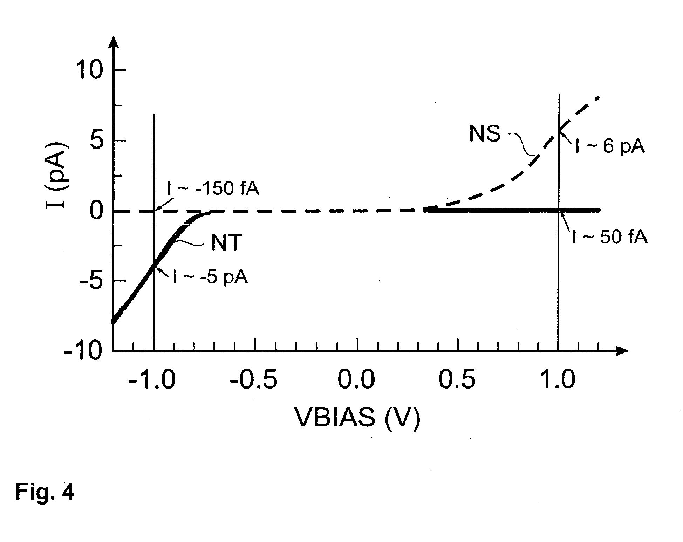

The two states of the molecule-atom complex give rise to characteristic conductances. Figure 4 shows the current voltage characteristic of a molecular memory device according to the arrangement shown in figure 2. The curve NS (dashed line) shows a current through the molecule-atom complex i.e. the PTCDA-Au complex, caused by tunneling from the copper layer 2 onto the complex and off the complex through the void space between the tip 9 and the complex 4, 5, when a bias voltage VBIAS is applied to the terminals 7, 8. The curve NS shows the respective current I when the gold atom 5 is in its negative state as shown in figure 3A. The curve NT shows the resulting current if the gold atom 5 is in its neutral state as it is shown in figure 3B.

It can be seen from figure 4, that a high current at positive bias voltage of +1V corresponds to a first charge distribution state of the PTCDA-Au complex and a high current at negative bias voltage VBIAS of -1V corresponds to the second charge distribution state of the PTCDA-Au complex. By increasing the bias voltage either positively or negatively to about 1.5V, the charge distribution state of PTCDA-Au complex can be switched to the respective other state.

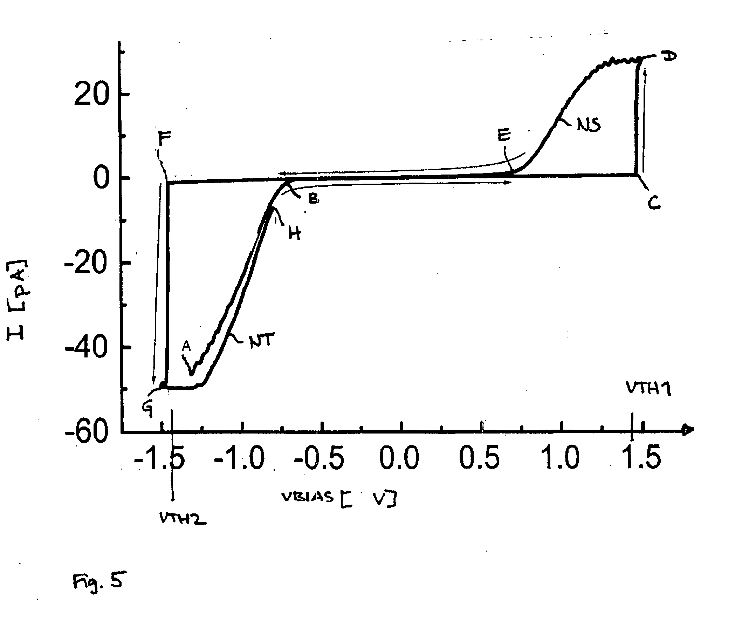

In figure 5, a complete switching cycle of the device shown in figure 2 is illustrated. The part of the curve corresponding to positive current values corresponds to the current running through the device if the gold atom is in its negative state NS while negative currents correspond to the charge distribution state of the PTCDA-Au complex where gold is in its neutral state.

Starting from the latter state, at approximately -47pA and a bias voltage of -1.3 V, denoted point A in figure 5, and increasing the bias voltage positively first, the negative amount of current decreases and reaches almost zero value at point B. Increasing the bias voltage VBIAS further the PTCDA-Au complex remains in its charge-distribution state, and the current I is basically unchanged. The current I remains approximately zero until the first threshold voltage VTH1 is reached at about 1.4 V corresponding to point C in figure 5. Increasing the bias voltage further than VTH 1, the charge-distribution state of the PTCDA-Au complex is changed. This can be seen from the sharp increase in current between points C and D in the curve. Hence, by increasing the bias voltage and exceeding the threshold voltage value VTH1 the charge-distribution state of the PTCDA-Au complex is programmed. Now, the gold atom is in its neutral state.

The bias voltage is again decreased and the current reaches approximately zero current at about 0.6 V again, denoted as point E on the curve. Further decreasing the bias voltage and turning the bias voltage VBIAS negative first the current remains approximately constant about zero until a second threshold voltage VTH2 is reached at about -1.4 V, point F in the curve. Again, a large change in the current occurs and reaches -50pA at point G. This means that by decreasing the bias voltage VBIAS further than VTH2 the memory state or the charge-distribution state of the PTCDA-Au complex is changed or reversed. Again, increasing the absolute value of the bias voltage leads to a decrease of the absolute value of the negative current.

Figure 5 therefore shows a closed switching cycle for an embodiment of a memory device according to the present invention. A sideshift in the I-V characteristic at the beginning of the switching cycle between points A and B and the end of the switching cycle between points G and H is due to a variation in the distance between the STM tip 9 and the PTCDA-Au complex when changing the bias voltage. It can be seen from the switching cycle depicted in figure 5 that by applying a constant voltage of either plus or minus one volt and simultaneously measuring the current through the two terminal device a charge-distribution state, and hence the memory state can be read. As can be seen by the current values given in figure 4, the on/off-ratio at minus and plus one Volt is about 30 and 100, respectively. Depending on the sign of the bias voltage also the logic or the readout can be reversed. If, e.g. an alternating bias voltage VBIAS between +1 and -1 volt is applied to an embodiment of the present invention as e.g. shown in figure 2, the charge distribution state of the PTCDA-Au complex directly translates into different directions of the current flow.

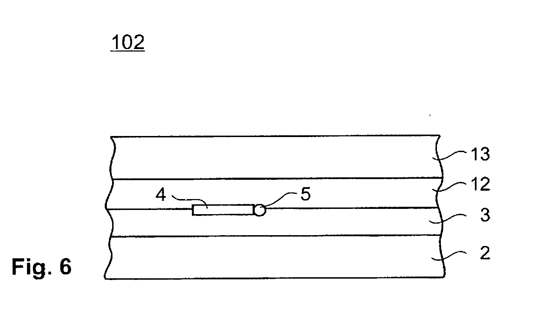

Figure 6 shows a second embodiment of a memory device according to the invention. In this embodiment, a molecule-atom complex e.g. a PTCDA molecule 4 with a gold atom 5 is embedded between two insulating layers 3, 12. Therefore, the second embodiment of the memory device 102 comprises a first metal layer 2, also referred to as first contact layer 2, e.g. of copper, a first insulating layer e.g. an atomic layer of NaCl being susceptible to polarization. The molecule 4 and atom 5 are placed onto the first insulating layer 3 and then covered with a second insulating layer 12 e.g. of several atomic layers of NaCl. Finally, the second contact/conducting layer 13, e.g. of copper, is provided on top of the second insulating layer 12.

It is an advantage if the work function of the first and second conducting layer 2, 13, the electron affinity of the molecule 4 and the electron affinity of the atom 5 are similar. By embedding the molecule-atom complex 4, 5 in the insulating material of 3, 12, first the molecule-atom complex is protected against impurities and second it is mechanically stabilized against thermal excitations and diffusive processes. In this embodiment of the memory cell 102 the first insulating NaCl layer 3 acts as a tunnel junction between the copper layer 2 and the molecule-atom complex 4, 5 and the second insulating layer of NaCl 12 acts as a second tunnel junction between the molecule-atom complex 4, 5 and the second conducting/contact layer of copper 13. Alternatively, the contact layers 2 and 13 can also be fabricated of a doped semiconductor material. By appropriately setting the amount of doping, the Fermi energy of such semiconductor contacts can be engineered to match the energy structure of the molecular states of the molecule-atom complex.

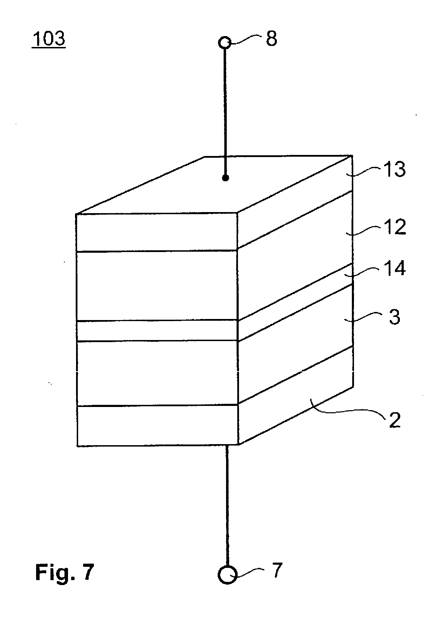

Figure 7 shows a view of a third embodiment of the memory device according to the invention. The memory cell 103 comprises a first metal layer 2, a first insulating layer 3, a layer 14 containing a plurality of molecule-atom complexes, which are preferably distributed in a mono-layer, second insulating layer 12 and a second contact layer 13. Mono-layers of molecule-atom complexes can be fabricated by known self-assembling techniques or for instance by evaporating first organic molecules like PTCDA and eventually placing atoms into such a layer. Again, the metallic or conducting layers 2 and 13 can be coupled to terminals 7, 8 for providing a two-terminal memory device. Even if several molecule-atom complexes are between the contact layers 2 and 13, the resulting tunneling current resembles the characteristics as shown in figures 4 and 5 but corresponds to the average tunneling current through the molecular-atom complexes.

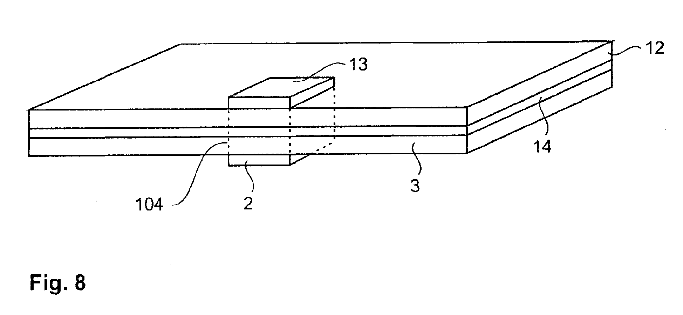

Figure 8 shows a fourth embodiment of a memory cell according to the present invention 104. First, a layer or substrate of insulating material 3, for instance a metal oxide or appropriate semiconductor material is provided and a layer of molecule-atom complexes 14 as described above is fabricated on the insulating layer 3. A second insulating layer 12 is placed on top of the layer 14 containing molecule-atom complexes such that the insulating material 3 and 12 may act as tunnel junctions. There are two conducting plates or pads 2, 13, provided on the first insulating layer 3 and the second insulating layer 12. The region between metal pads 2, 13 comprising parts of the insulating layers 3, 12 and the layer 14 containing the molecule-atom complexes form the actual memory cell 104 corresponding to the embodiment shown in figure 7. It is an advantage that by patterning the metal pads 2, 13 several memory cells 104 can be created by using a single sandwiched structure of insulators and molecule-atom complexes as shown in figure 8.

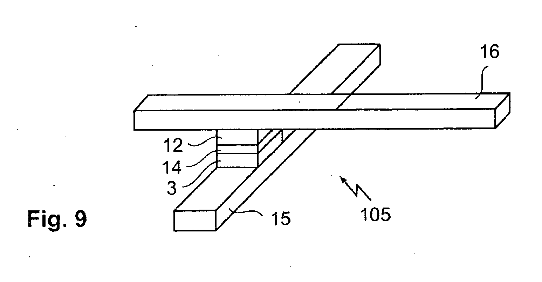

Figure 9 shows a fifth embodiment of a memory cell 105 according to the present invention. As in figure 8, a sandwich structure of two insulating layers 3, 12 and a layer 14 containing molecule-atom complexes is placed between conducting lines 15, 16 which are essentially arranged perpendicular to each other. Hence, lines 15 and 16 may be regarded as a word- and a bit-line, respectively.

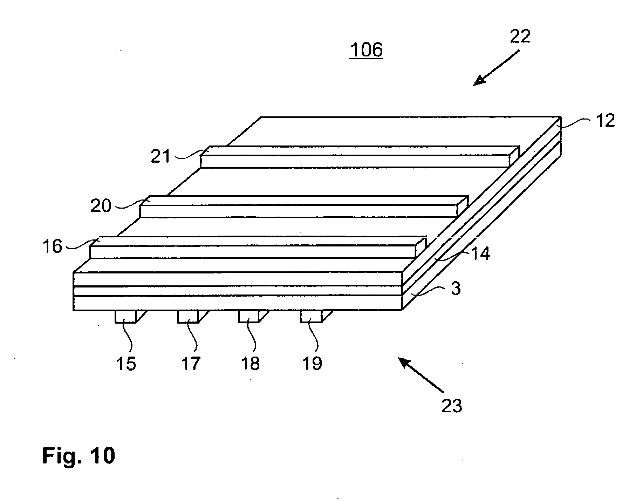

Figure 10 shows a memory cell array 106 comprising a plurality of sets of memory cells according to the present invention. The memory cell array 106 is built by a sandwiched structure as shown in figure 8 comprising two insulating layers 3, 12 and a layer 14 containing molecule-atom complexes as described above. On the top side 22 of the second insulating layer 12 a plurality of word-lines 16, 20, 21 is placed. On the bottom side of the first insulating layer 3 a plurality of bit-lines 15, 17,18, 19 is placed. The bit-lines 15, 17, 18, 19 are essentially perpendicularly arranged with respect to the word-lines 16, 20, 21. In the regions where bit-lines 15, 17, 18, 19 cross the word-lines 16, 20, 21 memory cells according to an embodiment of the present invention develop. This is similar to what is shown in figure 9 for a single crossing of a word- and a bit-line.

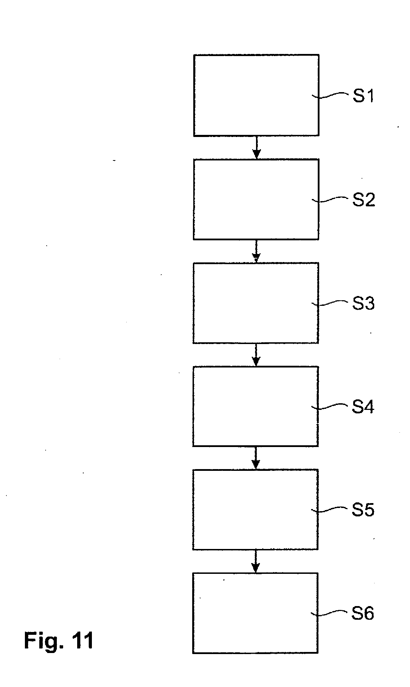

Figure 11 shows a diagram of essential fabrication steps for fabricating a memory cell according to the present invention. The method steps are to be understood in conjunction with the description of the preferred embodiments as shown in the foregoing figures.

In a first step S1, a first contact layer 2, e.g. of copper is provided. In a second step S2, a first insulating layer 3, e.g. comprising NaCl mono-atomic layers is located on the first contact layer 2. Then, at least one molecule 4, e.g. PTCDA is placed on the first insulating layer 3 in step S3. For creating a molecule-atom complex, a single atom 5, e.g. gold, platinum or silver is placed in the vicinity of the molecule 4 provided on the insulating layer 3 in step S4. The distance between the molecule 4 and the single atom 5 is then adjusted for instance by STM or self-assembly techniques in such a manner that a chemical bond 6 may form between the molecule 4 and the single atom 5 resulting in a PTCDA-Au-like complex 4, 5, 6 as described above. On top of the created molecule-atom complex 4, 5, 6, a second insulating layer 12 is provided, for instance another mono-atomic NaCl layer covering molecule-atom complex 4, 5, 6, in step S5. Finally, a second conducting/contact layer 13 is provided on top of the second insulating layer 12 in step S6.

What has been described herein is merely illustrative of the application of the principles of the present invention. Other arrangements and methods, such as using different substrates, molecules or known fabrication techniques, may be implemented by those skilled in the art without departing from the scope of this invention as defined by the appended claims.

## Claims

1. A memory device (1, 101) comprising a molecule-atom complex (4, 5, 6) arranged on a first insulating layer (3), wherein a first memory state of the memory device (1, 101) corresponds to a first charge distribution state of the molecule-atom complex (4, 5, 6) and a second memory state of the memory device (1, 101) corresponds to a second charge distribution state of the molecule-atom complex (4, 5, 6), wherein the total charge of the molecule-atom complex (4, 5, 6) corresponding to the first memory state is equal to the total charge of the molecule-atom complex (4, 5, 6) corresponding to the second memory state, said first insulating layer (3) being formed on a first contact layer (2) and said molecule-atom complex (4, 5, 6) comprising at least a single atom (5) and at least a molecule (4) on said first insulating layer (3);
wherein the single atom (5) and the molecule (4) of said molecule-atom complex (4, 5, 6) are as closely arranged on said first insulating layer (3) that a chemical bond (6) forms between the molecule (4) and the single atom (5).

2. The memory device (1, 101) according to claim 1 wherein said first insulating layer (3) forms a first tunnel junction between said molecule-atom complex (4, 5, 6) and said first contact layer (2).

3. The memory device (102, 103, 104, 105) according to any one of claims 1 to 2, wherein the memory device further (102, 103, 104, 105) comprises a second insulating layer (12) arranged on said molecule-atom complex (4, 5, 6) and a second contact layer (13) arranged on said second insulating layer (12), said second insulating layer (12) forming a second tunnel junction between said molecule-atom complex (4, 5, 6) and said second contact layer (13).

4. The memory device (101) according to any one of claims 1 to 2, wherein the memory device (101) further comprises a contact means (9) being arranged in the vicinity of said molecule-atom complex (4, 5, 6), wherein said contact means (9) and said molecule-atom complex (4, 5, 6) are separated by a void space, said void space forming a second tunnel junction between said molecule-atom complex (4, 5, 6) and said contact means (9).

5. The memory device (1, 101, 102, 103, 104, 105) according to claim 3, wherein said first insulating layer (3) comprises a polarizable material (10, 11), said polarizable material (10, 11) being polarized in response to said first and/or second charge-distribution state of the molecule-atom complex (4, 5, 6),
and wherein said second insulating layer (12) preferably comprises a polarizable material, said polarizable material being polarized in response to said first and/or second charge-distribution state of the molecule-atom complex (4, 5, 6).

6. The memory device (101, 102, 103, 104, 105) according to claim 3, wherein a bias voltage (VBIAS) is applied between said first contact layer (2) and said second contact layer (13) or between said first contact layer (2) and said contact means (9), respectively, for inducing said first memory state or said second memory state.

7. The memory device (1, 101, 102, 103, 104, 104, 105) according to any one of claims 1 to 6, wherein said molecule (4) comprises an organic molecule, and is selected to be a molecule of the group of oligoacenes, Metal-Phthalocyanines, or perylenetetracarboxylicacid-dianhydride (PTCDA).

8. The memory device according to claim 1, arranged as a memory cell (102, 103, 104, 105) comprising the first contact layer (2), with the first insulating layer (3) on the first contact layer (2), the molecule-atom complex (4, 5, 6) arranged on the first insulating layer (3), and further comprising a second insulating layer (12) on the molecule-atom complex (4, 5, 6), and a second contact layer (13) on the second insulating layer (12), wherein said first and said second insulating layer (3, 12) each forms a tunnel junction between said molecule-atom complex (4, 5, 6) and said first contact layer (2) and said second contact layer (13), respectively.

9. The memory device arranged as a memory cell (102, 103, 104, 105) according to claim 8, wherein said molecule-atom complex (4, 5, 6) comprises a single atom (5) and a molecule (4), said molecule-atom complex (4, 5, 6) having at least a first charge-distribution state corresponding to a first memory state of the memory cell (102, 103, 104, 105) and a second charge-distribution state corresponding to a second memory state of the memory cell (102, 103, 104, 105),
and wherein:
the total charge of the molecule-atom complex (4, 5, 6) corresponding to the first memory state is equal to the total charge of the molecule-atom complex (4, 5, 6) corresponding to the second memory state.

10. The memory device arranged as a memory cell (103, 104, 105) according to claims 8 or 9, wherein a plurality of molecule-atom complexes (14) of the same type are arranged between said first contact layer (2) and said second contact layer (13), each of said plurality of molecule-atom complexes (14) being separated from said first contact layer (2) by said first insulating layer (3) and from said second contact layer (13) by said second insulating layer (12), respectively.

11. The memory device arranged as a memory cell (102, 103, 104, 105) according to any one of claims 8 to 10, wherein said molecule (4) of the molecule-atom complex (4, 5, 6) comprises perylene-tetracarboxylicacid-dianhydride (PTCDA); said single atom (5) comprises a gold (Au) atom, a platinum (Pt) atom or a silver (Ag) atom; said first and/or second insulating layer (3, 12) comprises a monolayer, a bilayer or a trilayer of NaCl, other alkali halides, a metal oxide or a semiconductor oxide; and said first and/or second contact layer (2, 13) comprises copper (Cu) or a semiconductor material.

12. A memory cell array (106) comprising a plurality of memory devices arranged as memory cells (102, 103, 104, 105) according to any one of claims 8 to 11, wherein each memory cell (102, 103, 104, 105) is arranged between a word line (16, 20, 21) and a bit line (15, 17, 18, 19), said word line (16, 20, 21) being electrically coupled to said first contact layer (3) of the memory cell (102, 103, 104, 105) and said bit line (15, 17, 18, 19) being electrically coupled to said second contact layer (12) of the memory cell (102, 103, 104, 105).

13. The memory cell array (106) according to claim 12, wherein a set of memory cells (102, 103, 104, 105) shares a common word line (16, 20, 21).

14. A method for fabricating a memory cell (102, 103, 104, 105), the method comprising the method steps:
- providing a first contact layer (2);
- providing a first insulating layer (3) on said first contact layer (2);
- providing at least one molecule (4) on said first insulating layer (3);
- placing a single atom (5) in the vicinity of said at least one molecule (4), wherein a distance between the molecule (4) and the single atom (5) is adjusted in such a manner that a chemical bond (6) forms between the molecule (4) and the single atom (5) resulting in a molecule-atom complex (4, 5, 6);
- providing a second insulating layer (12) on said molecule-atom complex (4, 5, 6); and
- providing a second contact layer (13) on the second insulating layer (12),
wherein:
said molecule (4) and said single atom (5) are chosen in a manner that said molecule-atom complex (4, 5, 6) has a first charge-distribution state and a second charge-distribution state,
wherein the first and the second charge-distribution state correspond to the same total charge of the molecule-atom complex (4, 5, 6).

## Patentansprüche

1. Speichereinheit (1, 101), die einen Molekül-Atomkomplex (4, 5, 6) umfasst, der auf einer ersten Isolationsschicht (3) angeordnet ist, wobei ein erster Speicherzustand der Speichereinheit (1, 101) zu einem ersten Ladungsverteilungs-Zustand des Molekül-Atomkomplexes (4, 5, 6) und ein zweiter Speicherzustand der Speichereinheit (1, 101) zu einem zweiten Ladungsverteilungs-Zustand des Molekül-Atomkomplexes (4, 5, 6) gehört, wobei die Gesamtladung des Molekül-Atomkomplexes (4, 5, 6), die zu dem ersten Speicherzustand gehört, mit der Gesamtladung des Molekül-Atomkomplexes (4, 5, 6) übereinstimmt, die zu dem zweiten Speicherzustand gehört, die erste Isolationsschicht (3) auf einer ersten Kontaktschicht (2) gebildet wird, und der Molekül-Atomkomplex (4, 5, 6) wenigstens ein Einzelatom (5) und wenigstens ein Molekül (4) auf der ersten Isolationsschicht (3) umfasst, wobei das Einzelatom (5) und das Molekül (4) des Molekül-Atomkomplexes (4, 5, 6) zueinander so nahe auf der ersten Isolationsschicht (3) angeordnet sind, dass eine chemische Bindung zwischen dem Molekül (4) und dem Einzelatom (5) entsteht.

2. Speichereinheit (1, 101) nach Anspruch 1, wobei die erste Isolationsschicht (3) eine erste Tunnelverbindung zwischen dem Molekül-Atomkomplex (4, 5, 6) und der ersten Kontaktschicht (2) bildet.

3. Speichereinheit (102, 103, 104, 105) nach einem der Ansprüche 1 oder 2, wobei die Speichereinheit (102, 103, 104, 105) eine zweite Isolationsschicht (12), die auf dem Molekül-Atomkomplex (4, 5, 6) angeordnet ist, und eine zweite Kontaktschicht (13) umfasst, die auf der zweiten Isolationsschicht angeordnet ist, wobei die zweite Isolationsschicht (12) eine zweite Tunnelverbindung zwischen dem Molekül-Atomkomplex (4, 5, 6) und der zweiten Kontaktschicht (13) bildet.

4. Speichereinheit (101) nach einem der Ansprüche 1 oder 2, wobei die Speichereinheit (101) ferner ein Kontaktmittel (9) umfasst, das in der Nähe des Molekül-Atomkomplexes (4, 5, 6) angeordnet ist, wobei das Kontaktmittel (9) und der Molekül-Atomkomplex (4, 5, 6) durch eine Lücke getrennt sind und die Lücke eine zweite Tunnelverbindung zwischen dem Molekül-Atomkomplex (4, 5, 6) und dem Kontaktmittel (9) bildet.

5. Speichereinheit (1, 101, 102, 103, 104, 105) nach Anspruch 3, wobei die erste Isolationsschicht (3) ein polarisierbares Material (10, 11) umfasst, wobei das polarisierbare Material (10, 11) in Reaktion auf den ersten und/oder den zweiten Ladungsverteilungs-Zustand des Molekül-Atomkomplexes (4, 5, 6) polarisiert wird, und wobei die zweite Isolationsschicht (12) vorzugsweise ein polarisierbares Material umfasst, wobei das polarisierbare Material in Reaktion auf den ersten und/oder zweiten Ladungsverteilungs-Zustand des Molekül-Atomkomplexes (4, 5, 6) polarisiert wird.

6. Speichereinheit (101, 102, 103, 104, 105) nach Anspruch 3, wobei eine Vorspannung (VBIAS) zwischen der ersten Kontaktschicht (2) und der zweiten Kontaktschicht (13) bzw. zwischen der ersten Kontaktschicht (2) und dem Kontaktmittel (9) zum Einstellen des ersten Speicherzustands oder des zweiten Speicherzustands angelegt wird.

7. Speichereinheit (1, 101, 102, 103, 104, 105) nach einem der Ansprüche 1 bis 6, wobei das Molekül (4) ein organisches Molekül umfasst und es sich um ein Molekül aus der Gruppe der Oligoacene, Metall-Phtalocyanine oder Perylen-Tetracarboxylsäure-Dianhydride (PTCDA) handelt.

8. Speichereinheit nach Anspruch 1, die als eine Speicherzelle (102, 103, 104, 105) angeordnet ist, die die erste Kontaktschicht (2) mit der ersten Isolationsschicht (3) auf der ersten Kontaktschicht (2), den auf der ersten Isolationsschicht (3) angeordneten Molekül-Atomkomplex (4, 5, 6), ferner eine zweite Isolationsschicht (12) auf dem Molekül-Atomkomplex (4, 5, 6) und eine zweite Kontaktschicht (13) auf der zweiten Isolationsschicht (12) umfasst, wobei die erste und zweite Isolationsschicht (3, 12) jeweils eine Tunnelverbindung zwischen dem Molekül-Atomkomplex (4, 5, 6) und der ersten Kontaktschicht (2) bzw. der zweiten Kontaktschicht (13) bilden.

9. Speichereinheit, die als Speicherzelle (102, 103, 104, 105) nach Anspruch 8 angeordnet ist, wobei der Molekül-Atomkomplex (4, 5, 6) ein Einzelatom (5) und ein Molekül (4) umfasst und der Molekül-Atomkomplex (4, 5, 6) wenigstens einen ersten Ladungsverteilungs-Zustand, der einem ersten Speicherzustand der Speicherzelle (102, 103, 104, 105) entspricht, und einen zweiten Ladungsverteilungs-Zustand aufweist, der einem zweiten Speicherzustand der Speicherzelle (102, 103, 104, 105) entspricht, und wobei:
die Gesamtladung des Molekül-Atomkomplexes (4, 5, 6), die zu dem ersten Speicherzustand gehört, mit der Gesamtladung des Molekül-Atomkomplexes (4, 5, 6) übereinstimmt, der zu dem zweiten Speicherzustand gehört.

10. Speichereinheit, die als eine Speicherzelle (103, 104, 105) nach Anspruch 8 oder 9 angeordnet ist, wobei eine Vielzahl von gleichartigen Molekül-Atomkomplexen (14) zwischen der ersten Kontaktschicht (2) und der zweiten Kontaktschicht (13) angeordnet sind, wobei jeder Molekül-Atomkomplex aus der Vielzahl von Molekül-Atomkomplexen (14) von der ersten Kontaktschicht (2) durch die erste Isolationsschicht (3) bzw. von der zweiten Kontaktschicht (13) durch die zweite Isolationsschicht (12) getrennt ist.

11. Speichereinheit, die als Speicherzelle (102, 103, 104, 105) nach einem der Ansprüche 8 bis 10 angeordnet ist, wobei das Molekül (4) aus dem Molekül-Atomkomplex (4, 5, 6) ein Perylen-Tetracarboxyl-Dianhydrid (PTCDA) umfasst; das Einzelatom (5) ein Goldatom (Au), ein Platinatom (Pt) oder ein Silberatom (Ag) umfasst; die erste und/oder zweite Isolationsschicht (3, 12) eine Monoschicht, eine Doppelschicht oder eine Dreifachschicht aus NaCl, andere Alkalihalide, ein Metalloxid oder ein Halbleiteroxid umfasst; und die erste und/oder zweite Kontaktschicht (2, 13) Kupfer (Cu) oder ein Halbleitermaterial umfasst.

12. Speicherzellen-Anordnung (106), die eine Vielzahl von Speichereinheiten umfasst, die als Speicherzellen (102, 103, 104, 105) nach einem der Ansprüche 8 bis 11 angeordnet sind, wobei jede Speicherzelle (102, 103, 104, 105) zwischen einer Wortleitung (16, 20, 21) und einer Bitleitung (15, 17, 18, 19) angeordnet ist, wobei die Wortleitung (16, 20, 21) elektrisch mit der ersten Kontaktschicht (3) der Speicherzelle (102, 103, 104, 105) und die Bitleitung (15, 17, 18, 19) elektrisch mit der zweiten Kontaktschicht (12) der Speicherzelle (102, 103, 104, 105) verbunden ist.

13. Speicherzellenanordnung (106) nach Anspruch 2, wobei ein Satz von Speicherzellen (102, 103, 104, 105) eine gemeinsame Wortleitung (16, 20, 21) nutzt.

14. Verfahren zum Herstellen einer Speicherzelle (102, 103, 104, 105), wobei das Verfahren die folgenden Schritte umfasst:
- Bereitstellen einer ersten Kontaktschicht (2);
- Bereitstellen einer ersten Isolationsschicht (3) auf der ersten Kontaktschicht (2);
- Bereitstellen wenigstens eines Moleküls (4) auf der ersten Isolationsschicht (3);
- Anordnen eines Einzelatoms (5) in der Nähe des wenigstens einen Moleküls (4), wobei ein Abstand zwischen dem Molekül und dem Einzelatom (5) so eingestellt wird, dass eine chemische Bindung (6) zwischen dem Molekül (4) und dem Einzelatom (5) ausgebildet wird, sodass ein Molekül-Atomkomplex (4, 5, 6) entsteht;
- Bereitstellen einer zweiten Isolationsschicht (12) auf dem Molekül-Atomkomplex (4, 5, 6); und
- Bereitstellen einer zweiten Kontaktschicht (13) auf der zweiten Isolationsschicht (12), wobei:
das Molekül (4) und das Einzelatom (5) so gewählt werden, dass der Molekül-Atomkomplex (4, 5, 6) einen ersten Ladungsverteilungs-Zustand und einen zweiten Ladungsverteilungs-Zustand aufweist, wobei der erste und der zweite Ladungsverteilungs-Zustand dieselbe Gesamtladung des Molekül-Atomkomplexes (4, 5, 6) aufweisen.

## Revendications

1. Unité de mémoire (1, 101) comprenant un complexe molécule-atome (4, 5, 6) agencé sur une première couche isolante (3), dans laquelle un premier état de mémoire de l'unité de mémoire (1, 101) correspond à un premier état de distribution de charge du complexe molécule-atome (4, 5, 6) et un second état de mémoire de l'unité de mémoire (1, 101) correspond à un second état de distribution de charge du complexe molécule-atome (4, 5, 6), dans laquelle la charge totale du complexe molécule-atome (4, 5, 6) correspondant au premier état de mémoire est égale à la charge totale du complexe molécule-atome (4, 5, 6) correspondant au second état de mémoire, ladite première couche isolante (3) étant formée sur une première couche de contact (2) et ledit complexe molécule-atome (4, 5, 6) comprenant au moins un atome individuel (5) et au moins une molécule (4) sur ladite première couche isolante (3), dans lequel l'atome individuel (5) et la molécule (4) dudit complexe molécule-atome (4, 5, 6) sont agencés assez étroitement sur ladite première couche isolante (3) pour qu'une liaison chimique (6) se forme entre la molécule (4) et l'atome individuel (5).

2. Unité de mémoire (1, 101) selon la revendication 1, dans laquelle ladite première couche isolante (3) forme une jonction à effet tunnel entre ledit complexe molécule-atome (4, 5, 6) et ladite première couche de contact (2).

3. Unité de mémoire (102, 103, 104, 105) selon l'une quelconque des revendications 1 à 2, dans laquelle l'unité de mémoire (102, 103, 104, 105) comprend en outre une seconde couche isolante (12) agencée sur ledit complexe molécule-atome (4, 5, 6) et une seconde couche de contact (13) agencée sur ladite seconde couche isolante (12), ladite seconde couche isolante (12) formant une seconde jonction à effet tunnel entre ledit complexe molécule-atome (4, 5, 6) et ladite seconde couche de contact (13).

4. Unité de mémoire (101) selon l'une quelconque des revendications 1 à 2, l'unité de mémoire (101) comprenant en outre un moyen de contact (9) étant agencé à proximité dudit complexe molécule-atome (4,5,6), dans laquelle ledit moyen de contact (9) et ledit complexe molécule-atome (4,5,6) sont séparés par un espace vide, ledit espace vide formant une seconde jonction à effet tunnel entre ledit complexe molécule-atome (4,5,6) et ledit moyen de contact (9).

5. Unité de mémoire (1, 101, 102, 103, 104, 105) selon la revendication 3, dans laquelle ladite première couche isolante (3) comprend un matériau polarisable (10, 11), ledit matériau polarisable (10, 11) étant polarisés en réponse audit premier et/ou second état de distribution de charge du complexe molécule-atome (4, 5, 6),
et dans laquelle ladite seconde couche isolante (12) comprend de préférence un matériau polarisable, ledit matériau polarisable étant polarisé en réponse audit premier et/ou second état de distribution de charge du complexe molécule-atome (4, 5, 6).

6. Unité de mémoire (101, 102, 103, 104, 105) selon la revendication 3, dans laquelle une tension électrique de polarisation (VBIAS) est appliquée entre ladite première couche de contact (2) et ladite seconde couche de contact (13) ou entre ladite première couche de contact (2) et ledit moyen de contact (9), respectivement, pour induire ledit premier état de mémoire ou ledit second état de mémoire.

7. Unité de mémoire (1, 101, 102, 103, 104, 105) selon l'une quelconque des revendications 1 à 6, dans laquelle ladite molécule (4) comprend une molécule organique, et est sélectionnée pour être une molécule du groupe des oligoacènes, des phtalocyanines métalliques ou du PTCDA (dianhydride pérylène-tétracarboxylique).

8. Unité de mémoire selon la revendication 1, agencée comme une cellule de mémoire (102, 103, 104, 105) comprenant la première couche de contact (2), avec la première couche isolante (3) sur la première couche de contact (2), le complexe molécule-atome (4, 5, 6) agencé sur la première couche isolante (3), et comprenant en outre une seconde couche isolante (12) sur le complexe molécule-atome (4, 5, 6) et une seconde couche de contact (13) sur la seconde couche isolante (12), dans laquelle la première et ladite seconde couche isolante (3, 12) forment chacune une jonction à effet tunnel entre ledit complexe molécule-atome (4, 5, 6) et ladite première couche de contact (2) et ladite seconde couche de contact (13), respectivement.

9. Unité de mémoire agencé comme une cellule de mémoire (102, 103, 104, 105) selon la revendication 8, dans laquelle ledit complexe molécule-atome (4, 5, 6) comprend un atome individuel (5) et une molécule (4), ledit complexe molécule-atome (4, 5, 6) comportant au moins un premier état de distribution de charge correspondant à un premier état de mémoire de la cellule de mémoire (102, 103, 104, 105) et un second état de distribution de charge correspondant à un second état de mémoire de la cellule de mémoire (102, 103, 104, 105),
et dans lequel :
la charge totale du complexe molécule-atome (4, 5, 6) correspondant au premier état de mémoire est égale à la charge totale du complexe molécule-atome (4, 5, 6) correspondant au second état de mémoire.

10. Unité de mémoire agencée comme une cellule de mémoire (103,104,105) selon la revendication 8 ou 9, dans laquelle une pluralité de complexes molécule-atome (14) du même type sont agencés entre ladite première couche de contact (2) et ladite seconde couche de contact (13), chacun de ladite pluralité de complexes molécule-atome (14) étant séparés de ladite première couche de contact (2) par ladite première couche isolante (3) et de ladite seconde couche de contact (13) par ladite seconde couche isolante (12), respectivement.

11. Unité de mémoire agencée comme une cellule de mémoire (102, 103, 104, 105) selon l'une quelconque des revendications 8 à 10, dans laquelle ladite molécule (4) du complexe molécule-atome (4, 5, 6) comprend du PTCDA (dianhydride pérylène-tétracarboxylique) ; ledit atome individuel (5) comprend un atome d'or (Au), un atome de platine (Pt) ou un atome d'argent (Ag) ; ladite première et/ou seconde couche isolante (3, 12) comprend une monocouche, une double couche ou une triple couche de NaCl, d'autres halogénures alcalin, un oxyde métallique ou un oxyde semi-conducteur ; et ladite première et/ou seconde couche de contact (2,13) comprend du cuivre (Cu) ou un matériau semi-conducteur.

12. Réseau de cellules de mémoire (106) comprenant une pluralité d'unités de mémoire agencées comme des cellules de mémoire (102, 103, 104, 105) selon l'une quelconque des revendications 8 à 11, dans lequel chaque cellule de mémoire (102, 103, 104, 105) est agencée entre une ligne de mot (16, 20, 21) et une ligne de bit (15, 17, 18, 19), ladite ligne de mot (16, 20, 21) étant connectée électriquement à ladite première couche de contact (3)de la cellule de mémoire (102, 102, 104, 105) et ladite ligne de bit (15, 17, 18, 19) étant connectée électriquement à ladite seconde couche de contact (12) de la cellule de mémoire (102, 103, 104, 105).

13. Réseau de cellules de mémoire (106) selon la revendication 12, dans lequel un ensemble de cellules de mémoire (102, 103, 104, 105) partage une ligne de mot commune (16, 20, 21).

14. Procédé de fabrication d'une cellule de mémoire (102, 103, 104, 105), le procédé comprenant les étapes de procédé consistant à :
- fournir une première couche de contact (2) ;
- fournir une première couche isolante (3) sur ladite première couche de contact (2) ;
- fournir au moins une molécule (4) sur ladite première couche isolante (3) ;
- placer un atome individuel (5) à proximité de ladite au moins une molécule (4), dans lequel une distance entre la molécule (4) et l'atome individuel (5) est ajustée d'une manière telle qu'une liaison chimique (6) se forme entre la molécule (4) et l'atome individuel (5) ce qui donne un complexe molécule-atome (4, 5, 6) ;
- fournir une seconde couche isolante (12) sur ledit complexe molécule-atome (4, 5, 6) ; et
- fournir une seconde couche de contact (13) sur la seconde couche isolante (12),
dans lequel :
ladite molécule (4) et ledit atome individuel (5) sont choisis d'une manière telle que ledit complexe molécule-atome (4, 5, 6) possède un premier état de distribution de charge et un second état de distribution de charge, dans lequel le premier et le second état de distribution de charge correspondent à la même charge totale du complexe molécule-atome (4, 5, 6).
